# EUROPEAN PATENT SPECIFICATION

(11) **EP 1 367 878 B1**
(45) Date of publication and mention of the grant of the patent: **21.03.2007**
(21) Application number: 02253720.3
(22) Date of filing: 27.05.2002
(51) Int. Cl.: H05K 7/20

(54) **Flow guiding-type heat-radiating fan module**
Lüftereinheit zur Wärmeabfuhr mit einer Strömungsführung
Module de ventilateurs dissipant la chaleur à guidage de flux

(43) Date of publication of application: 03.12.2003
(73) Proprietor: Zyxel Communications Corporation, Hsin-Chu, Taiwan (TW)
(72) Inventor: Lien, Cin-Hung, Hsin-Chu (TW)
(74) Representative: Dearing-Lambert, Peter Richard

(56) References cited:
- US-A- 5 788 467
- PATENT ABSTRACTS OF JAPAN vol. 018, no. 560 (E-1621), 26 October 1994 (1994-10-26) -& JP 06 204676 A (FUJITSU LTD), 22 July 1994 (1994-07-22)
- PATENT ABSTRACTS OF JAPAN vol. 2000, no. 03, 30 March 2000 (2000-03-30) -& JP 11 354962 A (FUJITSU I NETWORK SYSTEMS LTD), 24 December 1999 (1999-12-24)
- PATENT ABSTRACTS OF JAPAN vol. 013, no. 301 (E-785), 11 July 1989 (1989-07-11) -& JP 01 077999 A (FUJITSU LTD), 23 March 1989 (1989-03-23)
- PATENT ABSTRACTS OF JAPAN vol. 016, no. 579 (E-1299), 18 December 1992 (1992-12-18) -& JP 04 226098 A (TOSHIBA CORP), 14 August 1992 (1992-08-14)

## Description

### BACKGROUND OF THE INVENTION

The present invention is related to a flow guiding-type heat-radiating fan module, and more particularly to a heat-radiating fan module used in middle-size or large-size electronic mechanism. The flow guiding-type heat-radiating fan module is able to effectively guide the air flow and radiate the heat. In addition, the height of the heat-radiating fan assembly is reduced so that the useful internal space of the electronic mechanism is enlarged.

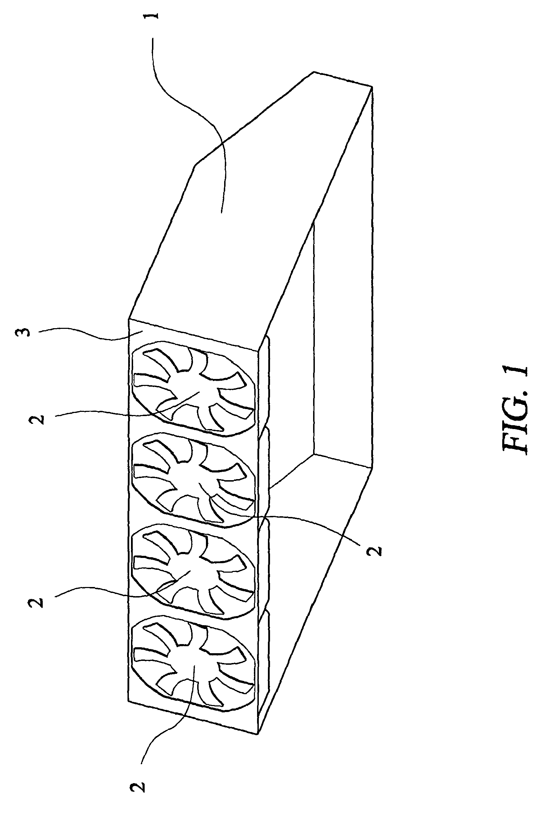

In general, a middle-size or large-size electronic mechanism is equipped with a heat-radiating device. For example, an electronic exchange, computer mainframe, industrial instrument and telecommunication equipment generally include fans for radiating heat. Fig. 1 shows that four heat-radiating fans 2 are used in a conventional electronic mechanism 1. The heat-radiating fans 2 are generally disposed on the top of the electronic mechanism 1. The hot air generated by the electronic mechanism 1 is sucked upward and then exhausted from rear side of the electronic mechanism 1. The heat-radiating fans 2 is uprightly fixed on the rear wall 3 of the housing of the electronic mechanism 1 so that much useful room of the electronic mechanism 1 is occupied and the electronic mechanism 1 will be higher and larger.

In the conventional heat-radiating fan, the connection of power wire is often the most problematic matter in service or replacement of the heat-radiating fan. This is because that the conventional heat-radiating fan lacks fixed design of location of power plug. Therefore, each time maintaining or replacing the heat-radiating fan, it is necessary to unplug and plug the power plug. This shortens using life of the power plug or even leads to increased impedance of the power plug and waste of power.

Examples of conventional heat-radiating fans for electronic equipment are described in JP 06204676A, JP11354962A, JP01077999A and US 5788467.

### SUMMARY OF THE INVENTION

It is therefore a primary object of the present invention to provide a flow guiding-type heat-radiating fan module in which the heat-radiating fans are modularized to reduce the height of the heat-radiating fans. In addition, the flow guiding-type heat-radiating fan module is able to guide the hot air and effectively radiate the heat.

In accordance with the present invention there is provided a flow guiding-type heat radiating fan module for mounting in a housing, the housing defining an internal space in which at least one electronic device is accommodated, lateral walls of the housing being formed with multiple heat-radiating holes and screw holes, the heat-radiating fan module comprising: a fan assembly tray to be removably arranged in the internal space of the housing, the fan assembly tray being formed with multiple inlets at least one fan being transversely disposed on the fan assembly tray for sucking hot air upward; and a flow guiding board disposed on upper side of the fan assembly tray, **characterised in that** the flow guiding board comprises a substantially V-shaped cross-section arranged to divert upward flow toward lateral walls the housing, whereby in use, the hot air generated by the electronic device is sucked upward by the fan, is blown the flow guiding board and is reflected thereby to pass through the heat-radiating holes so that the heat is radiated out of the housing.

In the above heat radiating fan module, two inclined seats are further disposed on the substrate of the fan assembly tray. Each inclined seat has a shape of non-isosceles triangle and is formed with two perforations. The fans are fixed on upper sides of the perforations and inclined toward the lateral walls of the housing by a certain inclination. Therefore, the fans can blow the hot air sucked from lower side through a shortest distance to exhaust the hot air out of the housing.

The above flow guiding-type heat-radiating fan module further includes a power circuit board perpendicularly disposed on the fan assembly tray. The power circuit board has a power socket for connecting with the power plug of the fan. An electric connector is provided on the power circuit board and directed to a rear wall of the housing. An electric socket is disposed on the rear wall of the housing opposite to the electric connector. The electric socket is adapted to connect with a power supply. When the fan assembly tray is inserted into the housing, the electric connector is plugged into the electric socket so that the power of the power supply can be supplied through the electric socket and the electric connector to the power circuit board so as to provide necessary power for the fan.

The present invention can be best understood through the following description and accompanying drawings wherein:

### BRIEF DESCRIPTION OF THE DRAWINGS

Fig. 1 is a perspective view of a conventional fan assembly used in an electronic mechanism;
Fig. 2 is a top perspective view showing that the present invention is inserted in the top section of the housing of an electronic mechanism;
Fig. 3 is a perspective exploded view of the present invention and the housing of the electronic mechanism;
Fig. 4 is a perspective exploded view of the fan assembly tray of the present invention;
Fig. 5 is a sectional view showing the flow guiding principle of the present invention;
Fig. 6 is a bottom perspective view showing that the present invention is partially inserted in the top section of the housing of the electronic mechanism;
Fig. 7 is a perspective view of the partitioning board of the present invention;
Fig. 8 is an enlarged view of the slide way and stop board of the partitioning board of the present invention; and
Fig. 9 is an enlarged view of the U-shaped clip plate of the partitioning board of the present invention.

### DETAILED DESCRIPTION OF THE PREFERRED EMBODIMENTS

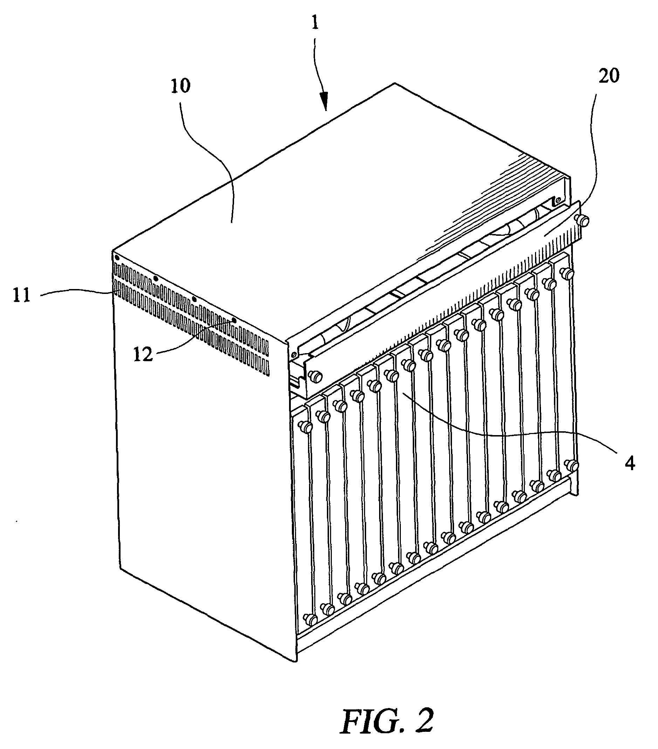

Please refer to Fig. 2. The heat-radiating fan module 20 of the present invention is mounted on the top of an electronic mechanism 1 for radiating the heat generated by several electronic devices 4 disposed on lower side. In this embodiment, the electronic mechanism 1 has a housing 10 as an elongated cabinet. The heat-radiating fan module 20 of the present invention can be inserted into or drawn out of the housing 10. The housing 10 defines an internal space in which the electronic devices 4 are accommodated. Two lateral walls of the housing 10 are formed with multiple heat-radiating holes 11 through which the hot air generated by the electronic devices 4 is radiated out of the housing. Multiple screws 12 are screwed through the lateral walls of the housing 10 for fixing internal components in the housing.

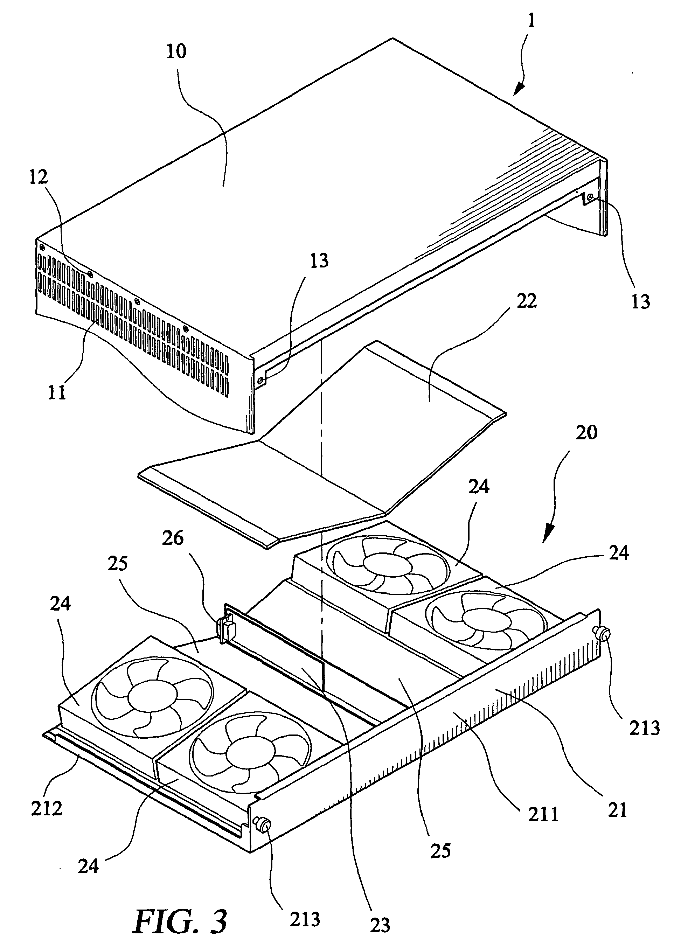

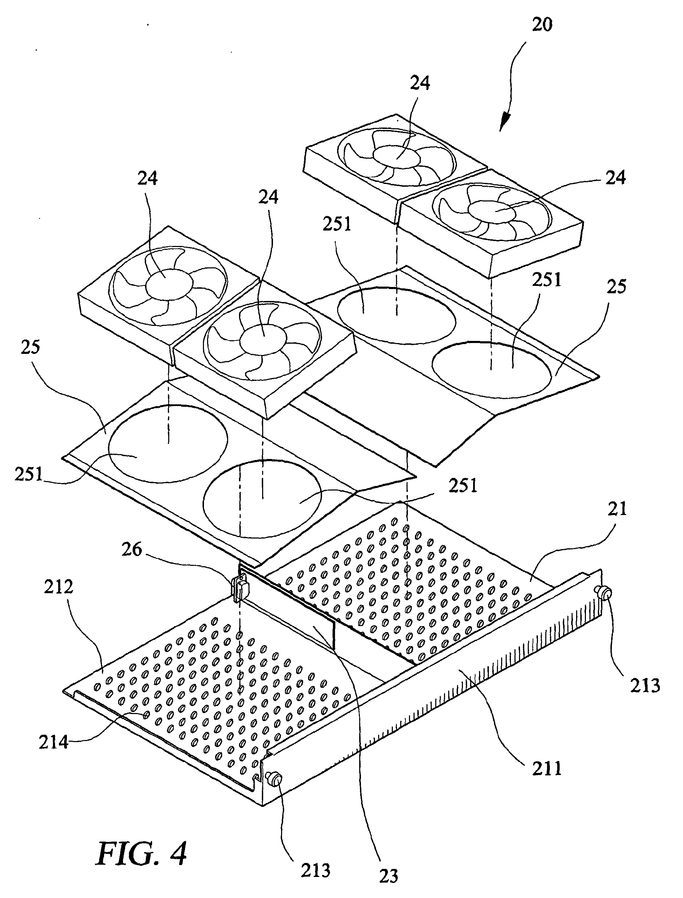

Fig. 3 is a perspective exploded view showing the connection between the heat-radiating fan module 20 and the housing 10. Fig. 4 is a perspective exploded view of the heat-radiating fan module 20. The heat-radiating fan module 20 of the present invention is composed of a fan assembly tray 21, a flow guiding board 22 and a power circuit board 23. The fan assembly tray 21 can be inserted into or drawn out of the internal space of the housing 10. The fan assembly tray 21 includes a panel 211 and a substrate 212. The panel 211 is provided with screws 213 for screwing into thread holes 13 of the housing 10 to fix the fan assembly tray 21 in a true position in the housing 10. Multiple fans 24 are arranged on the fan assembly tray 21. In this embodiment, there are four fans which are transversely disposed on the fan assembly tray 21. In addition, the fan assembly tray 21 is formed with multiple inlets 214 through which the hot air under the fan assembly tray 21 is sucked upward. In general, the present invention is mounted on uppermost layer of the housing 10. This is because the hot air will ascend and it is most efficient to suck the hot air to the uppermost layer.

The flow guiding board 22 is arranged on upper side of the fan assembly tray 21 and the fans 24 and fixed under the upper wall of the housing 10. The flow guiding board 22 is inclined from the upper wall of the housing 10 toward two lateral walls thereof. In this embodiment, as shown in Fig. 3, the flow guiding board 22 is left and right symmetrically formed and V-shaped. The flow guiding board 22 serves to reflect the hot air sucked by the fans 24 and guide the hot air out of the housing 10.

In addition, two inclined seats 25 are disposed on the fan assembly tray 21. Each inclined seat 25 has a shape of non-isosceles triangle. The inclined seats 25 are disposed on the substrate 212 of the fan assembly tray 21. Each inclined seat 25 is formed with two perforations 251. The fans 24 are fixed on upper side of the perforations 251 of the inclined seat 25, whereby the fans 24 are inclined toward the lateral walls of the housing 10 by a certain inclination. The inclined seats 25 mainly serve to shorten the distance through which the hot air is sent by the fans 24 out of the housing 10. Also, the inclined seats 25 serve to increase the angle of reflection of the hot air blowing to the flow guiding board 22. Therefore, it is easier to send the hot air out of the housing 10.

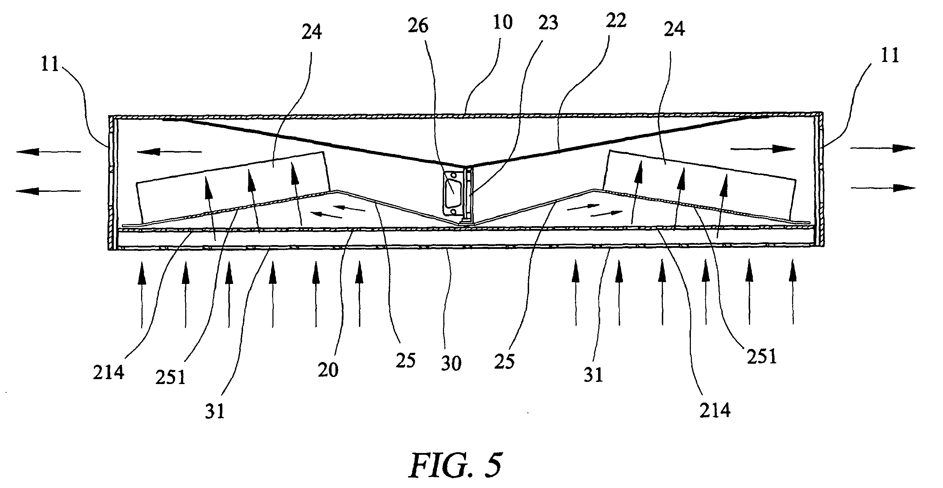

Please refer to Fig. 5 which shows the flow guiding principle of the present invention. In use, the hot air generated by the electronic devices 4 on lower side is upward sucked by the fans 24 disposed on the fan assembly tray 21. The hot air then blows to the flow guiding board 22 and is reflected by the inclined flow guiding board 22 to pass through the heat-radiating holes 11 of the lateral walls of the housing 10. The flow guiding board 22 has a left and right symmetrical pattern so that the hot air is radiated out of the housing 10 through the heat-radiating holes 11 of the lateral walls of the housing 10. Alternatively, the hot air can blow to rear side of the housing. However, the cabinet-like electronic mechanisms are mostly such positioned that the rear side of the housing is adjacent to a wall. Therefore, preferably the hot air is laterally radiated.

Referring to Fig. 3, the power circuit board 23 of the present invention is perpendicularly disposed on the fan assembly tray 21. The power plugs (not shown) of all the fans 24 can be plugged in a power socket (not shown) of the power circuit board 23. An electric connector 26 is provided on the power circuit board 23 and directed to the rear wall of the housing 10. An electric socket (not shown) is disposed on the rear wall opposite to the electric connector 26. The electric socket is connected with a power supply. When the fan assembly tray 21 is inserted into the housing 10, the electric connector 26 is plugged into the electric socket, whereby the power of the power supply can be supplied through the electric socket and the electric connector 26 to the power circuit board 23 so as to provide necessary power for the fans 24.

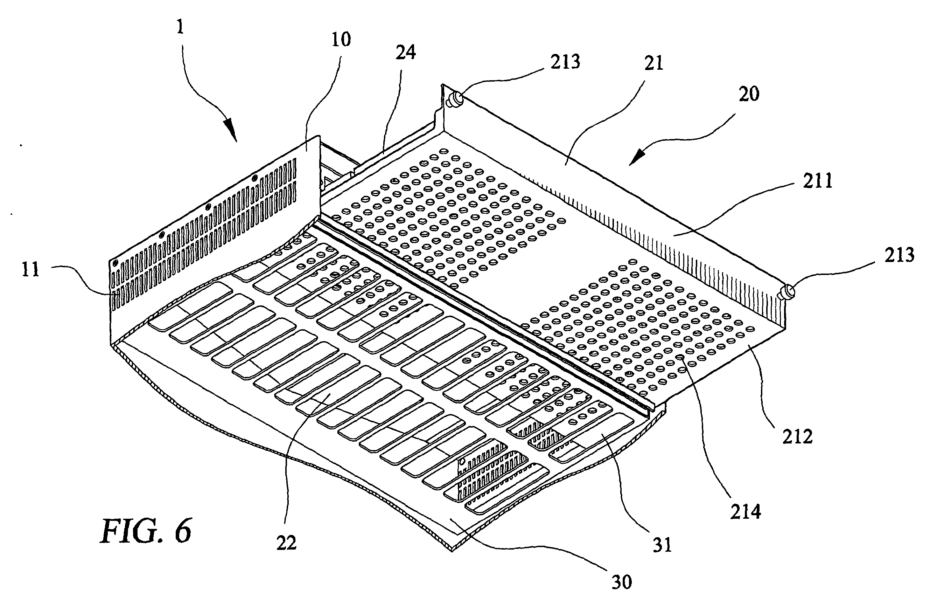

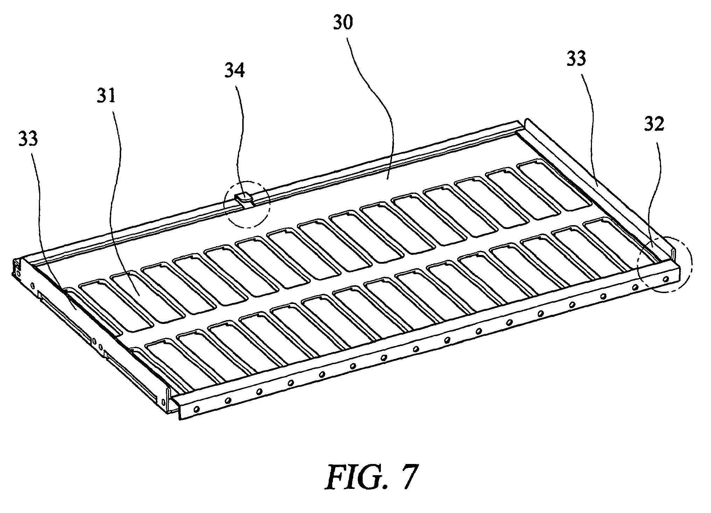

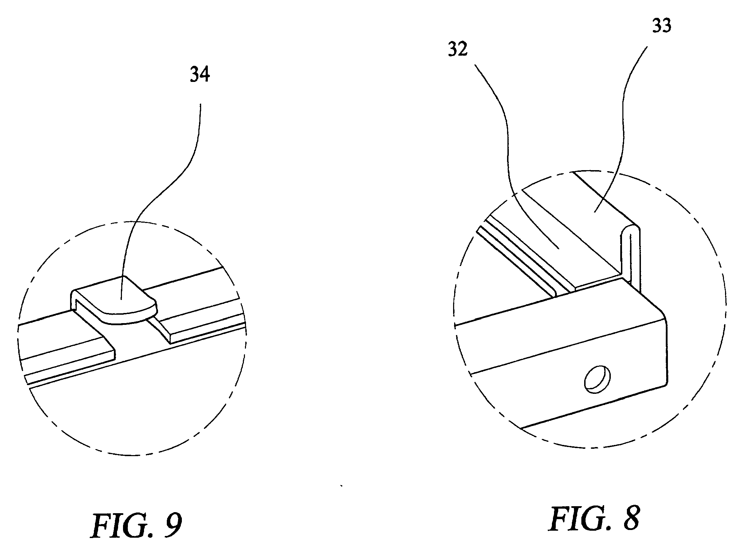

Please refer to Fig. 6 which is a bottom perspective view showing the connection between the fan module 20 and the housing 10. Multiple partitioning boards 30 are arranged in the internal space of the housing 10 for separating the respective electronic devices 4 from each other. Fig. 7 is a perspective view of the partitioning board 30. The partitioning board 30 is formed with multiple vents 31, whereby the hot air generated by the electronic devices 4 can be sucked from lower side to upper side. Each of two sides of the partitioning board 30 is formed with a slide way 32 and a stop board 33. Fig. 8 is an enlarged view showing the slide way and the stop board. The fan assembly tray 21 is slidably placed on the slide ways 32 of the partitioning board 30, whereby the fan assembly tray 21 can be smoothly inserted into or drawn out of the housing 10. The stop boards 33 serve to guide the fan assembly tray 21. In addition, a rear edge of the partitioning board 30 is punched with at least one U-shaped clip plate 34 as shown in Fig. 9. The U-shaped clip plate 34 serves to guide the electric connector 26 to accurately connect with the electric socket. The U-shaped clip plate 34 also serves to clamp the fan assembly tray 21, preventing the fan assembly tray 21 from swinging.

According to the above arrangement, the flow guiding-type heat-radiating fan module of the present invention is able to effectively guide the air flow and radiate the heat. In addition, the height of the heat-radiating fan assembly is reduced so that the useful internal space of the electronic mechanism is enlarged.

## Claims

1. A flow guiding-type heat radiating fan module (20) for mounting in a housing (10), the housing defining an internal space in which at least one electronic device (4) is accommodated, lateral walls of the housing being formed with multiple heat-radiating holes (11) and screw holes, the heat-radiating fan module comprising:
a fan assembly tray (21) to be removably arranged in the internal space of the housing (10), the fan assembly tray (21) being formed with multiple inlets (214); at least one fan (24) being transversely disposed on the fan assembly tray (21) for sucking hot air upward; and a flow guiding board (22) disposed on upper side of the fan assembly tray (21),
**characterised in that** the flow guiding board (22) comprises a substantially V-shaped cross-section arranged to divert upward flow toward the lateral walls of the housing, whereby in use, the hot air generated by the electronic device (4) is sucked upward by the fan (24), is blown to the flow guiding board (22) and is reflected thereby to pass through the heat-radiating holes (11) so that the heat is radiated out of the housing.

2. Flow guiding-type heat-radiating fan module as claimed in claim 1, further comprising at least one partitioning board (30), wherein the fan module comprises at least two electronic devices (4), the housing (10) comprising an elongated cabinet and the at least one partitioning board (30) being arranged in the internal space of the housing for separating the at least two electronic devices from each other, the or each partitioning board (30) being formed with multiple vents (31).

3. Flow guiding-type heat-radiating fan module as claimed in claim 2, wherein the partitioning board is formed with slide ways, whereby the fan assembly tray is slidably placed on the slide ways.

4. Flow guiding-type heat-radiating fan module as claimed in claim 2, wherein the partitioning board is punched with at least one U-shaped clip plate for clamping the fan assembly tray.

5. Flow guiding-type heat-radiating fan module as claimed in claim 1, wherein the flow guiding board is fixed on the upper wall of the housing.

6. Flow guiding-type heat-radiating fan module as claimed in claim 1, wherein the fan assembly tray includes a panel and a substrate, the panel being provided with screws for fixing the fan assembly tray in the housing.

7. Flow guiding-type heat-radiating fan module as claimed in claim 1, wherein at least one inclined seat is disposed on the substrate of the fan assembly tray, the inclined seat having a shape of non-isosceles triangle and being formed with at least one perforation, the fan being fixed on upper side of the perforation of the inclined seat, whereby the fan is inclined toward the lateral wall of the housing by a certain inclination for blowing the hot air sucked from lower side out of the housing.

8. Flow guiding-type heat-radiating fan module as claimed in claim 1, further comprising:
a power circuit board perpendicularly disposed on the fan assembly tray and connected with power wire of the fan;
an electric connector provided on the power circuit board and directed to a rear wall of the housing; and
an electric socket disposed on the rear wall of the housing opposite to the electric connector, the electric socket being adapted to connect with a power supply, whereby when the fan assembly tray is inserted into the housing, the electric connector is plugged into the electric socket so that the power of the power supply can be supplied through the electric socket and the electric connector to the power circuit board so as to provide necessary power for the fan.

## Patentansprüche

1. Lüftereinheit (20) zur Wärmeabfuhr mit einer Strömungsführung zur Befestigung in einem Gehäuse (10), wobei das Gehäuse einen Innenraum definiert, in dem wenigstens ein elektronisches Gerät (4) aufgenommen ist, wobei Seitenwände des Gehäuses mit einer Vielzahl von Wärme ableitenden Löchern (11) und Schraubenlöchern versehen sind, und die Wärme ableitende Lüftereinheit Folgendes enthält:
einen Lüfteraufnahmeträger (21), der im Innenraum des Gehäuses (10) entfernbar angeordnet ist, wobei der Lüfteraufnahmeträger (21) mit einer Mehrzahl von Einlässen (214) ausgebildet ist, wenigstens ein Lüfter (24) in Querrichtung auf dem Lüfteraufnahmeträger (21) zum Heraussaugen von heißer Luft nach oben angeordnet ist und eine Strömungsführungsplatte (22) an der Oberseite des Lüfteraufnahmeträgers (21) ausgebildet ist,
**dadurch gekennzeichnet, dass**
die Strömungsführungsplatte (22) einen im Wesentlichen V-förmigen Querschnitt aufweist, um den Aufwärtsstrom gegen die Seitenwände des Gehäuses zu leiten, wobei bei der Benutzung die heiße Luft, die durch das elektronische Gerät (4) erzeugt wird, und durch den Lüfter (24) nach oben gesaugt wird, gegen die Strömungsführungsplatte (22) geblasen und **dadurch** so abgelenkt wird, dass sie durch die Wärmeabgabelöcher (11) geleitet wird, so dass die Hitze aus dem Gehäuse abgestrahlt wird.

2. Lüftereinheit zur Wärmeabfuhr mit einer Strömungsführung nach Anspruch 1, welche ferner wenigstens eine Teilungsplatte (30) enthält, wobei die Lüftereinheit wenigstens zwei elektronische Geräte (4) enthält, und das Gehäuse (10) einen länglichen Schacht enthält und die wenigstens eine Teilungsplatte (30) im Innenraum des Gehäuses so angeordnet ist, dass die wenigstens zwei elektronischen Geräte voneinander getrennt sind, und die oder jede Teilungsplatte (30) mit einer Mehrzahl von Öffnungen (31) versehen sind.

3. Lüftereinheit zur Wärmeabfuhr mit einer Strömungsführung nach Anspruch 2, bei der die Teilungsplatte mit Schiebewegen ausgebildet ist, wobei der Lüfteraufnahmeträger auf den Schiebewegen verschiebbar angeordnet ist.

4. Lüftereinheit zur Wärmeabfuhr mit einer Strömungsführung nach Anspruch 2, bei der die Teilungsplatte mit wenigstens einer U-förmigen Klemmplatte zum Klemmen des Lüfteraufnahmeträgers gestanzt ist.

5. Lüftereinheit zur Wärmeabfuhr mit einer Strömungsführung nach Anspruch 1, bei der die Strömungsführungsplatte an der oberen Wand des Gehäuses befestigt ist.

6. Lüftereinheit zur Wärmeabfuhr mit einer Strömungsführung nach Anspruch 1, bei der der Lüfteraufnahmeträger eine Frontplatte und einen Boden aufweist, wobei die Frontplatte mit Schrauben zur Befestigung des Lüfteraufnahmeträgers im Gehäuse versehen ist.

7. Lüftereinheit zur Wärmeabfuhr mit einer Strömungsführung nach Anspruch 1, bei der wenigstens eine geneigte Aufnahme auf dem Boden des Lüfteraufnahmeträgers angeordnet ist, wobei die geneigte Aufnahme die Form eines ungleichschenkligen Dreiecks aufweist und mit wenigstens einem Durchbruch ausgebildet ist, wobei der Lüfter an der Oberseite des Durchbruchs der geneigten Aufnahme befestigt ist und der Lüfter gegen die Seitenwand des Gehäuses mit einer gewissen Schräge geneigt ist, um heiße Luft, die von der Unterseite des Gehäuses angesaugt wird, abzublasen.

8. Lüftereinheit zur Wärmeabfuhr mit einer Strömungsführung nach Anspruch 1, welche ferner folgendes enthält:
eine Netzteilschaltung, welche rechtwinklig auf dem Lüfteraufnahmeträger angeordnet ist und mit der Netzleitung des Lüfters verbunden ist;
einen elektrischen Verbinder, der an der Netzteilschaltung angeordnet ist und zur rückwärtigen Wand des Gehäuses gerichtet ist; und
einen elektrischen Sockel, der an der Rückwand des Gehäuses gegenüber dem elektrischen Verbinder angeordnet ist, wobei der elektrische Sockel zur Verbindung mit einer Stromzufuhr ausgebildet ist, wobei, wenn der Lüfteraufnahmeträger in das Gehäuse eingeführt wird, der elektrische Verbinder in den elektrischen Sockel eingesteckt wird, so dass die Energie des Netzteils über den elektrischen Sockel und den elektrischen Verbinder in die Netzteilschaltung abgeführt werden kann, um die notwendige Energie für den Lüfter zur Verfügung zu stellen.

## Revendications

1. Module de ventilateurs (20) dissipant la chaleur du type à guidage de flux destiné à être monté dans un logement (10), le logement définissant un espace intérieur dans lequel est reçu au moins un dispositif électronique (4), des parois latérales du logement étant formées avec de multiples trous (11) dissipant la chaleur et des trous de vis, le module de ventilateurs dissipant la chaleur comprenant :
un plateau (21) d'ensemble de ventilateurs à disposer de manière amovible dans l'espace intérieur du logement (10), le plateau (21) d'ensemble de ventilateurs étant formé avec de multiples entrées (214) ; au moins un ventilateur (24) étant disposé de manière transversale sur le plateau (21) d'ensemble de ventilateurs pour aspirer vers le haut l'air chaud ; et une plaque de guidage du flux (22) étant disposée sur le côté supérieur du plateau (21) d'ensemble de ventilateurs,
**caractérisé en ce que** la plaque (22) de guidage du flux présente une section transversale sensiblement en forme de V disposée pour dévier le flux vers le haut vers les parois latérales du logement, grâce à quoi en fonctionnement, l'air chaud généré par le dispositif électronique (4) est aspiré vers le haut par le ventilateur (24), est soufflé jusqu'à la plaque de guidage du flux (22) et est renvoyé ainsi de façon à traverser les trous (11) dissipant la chaleur de telle sorte que la chaleur soit rayonnée hors du logement.

2. Module de ventilateurs dissipant la chaleur du type à guidage de flux selon la revendication 1, comprenant en outre au moins une plaque de séparation (30), dans lequel le module de ventilateurs comprend au moins deux dispositifs électroniques (4), le logement (10) comprenant un coffret allongé et l'au moins une plaque de séparation (30) étant disposée dans l'espace intérieur du logement pour séparer les au moins deux dispositifs électroniques l'un de l'autre, la ou les plaques de séparation (30) étant formées chacune avec de multiples évents (31).

3. Module de ventilateurs dissipant la chaleur du type à guidage de flux selon la revendication 2, dans lequel la carte de séparation est formée avec des glissières, grâce à quoi le plateau d'ensemble de ventilateurs est placé de façon coulissante sur les glissières.

4. Module de ventilateurs dissipant la chaleur du type à guidage de flux selon la revendication 2, dans lequel la carte de séparation est poinçonnée avec au moins une plaque de fixation en forme de U pour fixer le plateau d'ensemble de ventilateurs.

5. Module de ventilateurs dissipant la chaleur du type à guidage de flux selon la revendication 1, dans lequel la carte de guidage du flux est fixée sur la paroi supérieure du logement.

6. Module de ventilateurs dissipant la chaleur du type à guidage de flux selon la revendication 1, dans lequel le plateau d'ensemble de ventilateurs comprend un panneau et un support, le panneau étant fourni avec des vis pour fixer le plateau d'ensemble de ventilateurs dans le logement.

7. Module de ventilateurs dissipant la chaleur du type à guidage de flux selon la revendication 1, dans lequel au moins un siège incliné est disposé sur le support du plateau d'ensemble de ventilateurs, le siège incliné présentant une forme de triangle non isocèle et étant formé avec au moins une perforation, le ventilateur étant fixé sur le côté supérieur de la perforation du siège incliné, grâce à quoi le ventilateur est incliné vers la paroi latérale du logement sous une certaine inclination pour souffler hors du logement l'air chaud aspiré en provenance du côté inférieur.

8. Module de ventilateurs dissipant la chaleur du type à guidage de flux selon la revendication 1, comprenant en outre :
une carte de circuit imprimé d'alimentation disposée perpendiculairement sur le plateau d'ensemble de ventilateurs et connectée aux fils d'alimentation du ventilateur ;
un connecteur électrique disposé sur la carte de circuit imprimé d'alimentation et dirigé vers la paroi arrière du logement ; et
une prise électrique disposée sur la paroi arrière du logement opposée au connecteur électrique, la prise électrique étant adaptée pour être connectée à une alimentation électrique, grâce à quoi lorsque le plateau d'ensemble de ventilateurs est inséré dans le logement, le connecteur électrique est branché dans la prise électrique de telle sorte que l'alimentation électrique puisse être délivrée par l'intermédiaire de la prise électrique et du connecteur électrique à la carte de circuit imprimé d'alimentation afin de fournir l'énergie nécessaire au ventilateur.
